# EUROPEAN PATENT APPLICATION

(11) **EP 3 932 537 A1**
(43) Date of publication of application: **05.01.2022**
(21) Application number: 20762494.1
(22) Date of filing: 07.02.2020
(51) Int. Cl.: B01J 19/08, G01N 37/00, B81B 1/00

(54) **OPEN SPACE TYPE LIQUID MANIPULATING DEVICE**

(30) Priority: 25.02.2019 JP 2019031670
(71) Applicant: NATIONAL INSTITUTE OF ADVANCED INDUSTRIAL SCIENCE AND TECHNOLOGY, Chiyoda-ku Tokyo 100-8921 (JP)
(72) Inventor: MOGI, Katsuo, Tokyo 135-0064 (JP); ADACHI, Shungo, Tokyo 135-0064 (JP); INOUE, Tomoya, Tsukuba-shi, Ibaraki 305-8560 (JP); NATSUME, Tohru, Tokyo 135-0064 (JP)
(74) Representative: HGF
(86) International application number: PCT/JP2020/004702
(87) International publication number: WO 2020/175083

(57) **Abstract**

An open-type liquid manipulation device can divide liquid, in particular, a droplet efficiently. The open-type liquid manipulation device according to the present invention includes: a substrate 1, 11, 21; at least three electrodes 2, 12, 13, 22, 23 located on a front surface 1b, 11b, 21b of the substrate 1, 11, 21; and an insulating layer 3, 14, 24 located over the front surface 1b, 11b, 21b of the substrate 1, 11, 21 to cover the at least three electrodes 2, 12, 13, 22, 23. The device includes a groove 4, 15, 25 that is concave in a direction from a front surface 3b, 14b, 24b of the insulating layer 3, 14, 24 toward a back surface 3a, 14a, 24a of the insulating layer 3, 14, 24. The groove 4, 15, 25 extends straddling the at least three electrodes. Liquid L is controlled on the front surface 3b, 14b, 24b of the insulating layer 3, 14, 24 by using a change in electrostatic force generated by changing voltage applied to the electrodes 2, 12, 13, 22, 23.

## Description

### [Technical Field]

The present invention relates to an open-type liquid manipulation device configured to manipulate liquid using electrostatic force.

### [Background Art]

Various technological fields, such as biotechnology, medicine, drug development, microelectromechanical systems (MEMS), and/or the like are increasingly focusing attention on EWOD (Electro Wetting On Dielectric). Based on EWOD, liquids, in particular, droplets are manipulated using electrostatic force. In particular, in the technological fields of biotechnology, medicine, drug development, and/or the like, EWOD has a great potential for handling rare reagents, dangerous agents, and/or the like. EWOD-based devices (liquid manipulation devices) may be categorized into two types: an open type and a closed type.

An open-type liquid manipulation device typically includes: a substrate; electrodes located on a front surface of the substrate; and an insulating layer having a back surface located over the front surface of the substrate to cover the electrodes, and a front surface opposing the back surface. The front surface of the insulating layer is open to the outside. The device is configured to change electrostatic force obtained based on the application of voltage to the electrodes to thereby manipulate a droplet on the front surface of the insulating layer. (See Non-Patent Document 1, for example.)

A closed-type liquid manipulation device typically includes: a substrate; control electrodes located on a front surface of the substrate; a first insulating layer having a back surface located over the front surface of the substrate to cover the control electrodes, and a front surface opposing the back surface; a second insulating layer having a front surface facing, and spaced apart from, the front surface of the first insulating layer, and a back surface opposing the front surface; and grounding electrodes located on the back surface of the second insulating layer at locations corresponding to respective locations of the control electrodes. The device is configured to change electrostatic force obtained based on the application of voltage to the control electrodes to thereby manipulate a droplet in a closed space between the first and second insulating layers.

There is a demand for liquid manipulation devices of both open type and closed type that have an enhanced ability to control a droplet. In particular, manipulation to divide a droplet is difficult and poses a problem in providing an enhanced ability to control a droplet.

Solutions to this problem have been reported for closed-type liquid manipulation devices, in which a droplet can be divided in the closed space between the first and second insulating layers by controlling the control electrodes to apply voltage to one of adjacent control electrodes among the control electrodes while applying no voltage to the other one of the adjacent control electrodes (see Non-Patent Documents 2 to 5, for example).

### [Citation List]

### [Non-Patent Document]

[Non-Patent Document 1] Hyojin Ko and seven others, "Active Digital Microfluidic Paper Chips with Inkjet-Printed Patterned Electrodes," ADVANCED MATERIALS, Volume 26, Issue 15, April 16, 2014, pp. 2335 to 2340
[Non-Patent Document 2] Michael George Pollack, "ELECTROWETTING-BASED MICROACTUATION OF DROPLETS FOR DIGITAL MICROFLUIDICS", Dissertation submitted in partial fulfillment of the requirements for the degree of Doctor of Philosophy in the Department of Electrical and Computer Engineering in the Graduate School of Duke University, 2001
[Non-Patent Document 3] Sung Kwon Cho and two others, "Creating, Transporting, Cutting, and Merging Liquid Droplets by Electrowetting-Based Actuation for Digital Microfluidic Circuits", JOURNAL OF MICROELECTROMECHANICAL SYSTEMS, VOL. 12, NO. 1, February 2003
[Non-Patent Document 4] H.-W. LU and three others, "A Diffuse Interface Model for Electrowetting Droplets in a Hele-Shaw Cell", Journal of Fluid Mechanics, Volume 590, November 10, 2007, pp. 411 to 435
[Non-Patent Document 5] N. Y. Jagath B. Nikapitiya and two others, "Accurate, consistent, and fast droplet splitting and dispensing in electrowetting on dielectric digital microfluidics", Micro and Nano Systems Letters 2017 5:24, June 16, 2017

### [Summary of Invention]

### [Technical Problem]

Open-type liquid manipulation devices are superior to closed-type liquid manipulation devices from the viewpoint of, in particular, the introduction and collection of a droplet, fabrication efficiency, fabrication costs, and the like. Thus, there is a desire to enhance the ability to control a droplet for open-type liquid manipulation devices. However, open-type liquid manipulation devices have difficulty in achieving manipulation to divide a droplet due to the effect of the surface tension of the droplet. This is because, in an open-type liquid manipulation device, the gas-liquid interface or liquid-liquid interface of a droplet being manipulated is greater than the solid-liquid interface, thus rendering the surface tension predominant.

In view of the circumstances described above, it is desired that an open-type liquid manipulation device have an ability to efficiently divide liquid, in particular, a droplet. Additionally, it is desired that the open-type liquid manipulation device have an enhanced ability to control liquid, in particular, a droplet.

### [Solution to Problem]

To provide a solution to the problem described above, an open-type liquid manipulation device according to an aspect includes: a substrate; at least three electrodes located on a front surface of the substrate; and an insulating layer located over the front surface of the substrate to cover the at least three electrodes, wherein the insulating layer has: a back surface facing the front surface of the substrate; and a front surface located opposite the back surface of the insulating layer with respect to a thickness direction of the insulating layer, the front surface of the insulating layer is open to outside, the liquid manipulation device is configured to control liquid on the front surface of the insulating layer by using a change in electrostatic force caused by changing voltage applied to the at least three electrodes, the device includes a groove that is concave in a direction from the front surface of the insulating layer toward the back surface of the insulating layer, and the groove extends straddling the at least three electrodes.

### [Advantageous Effects of Invention]

The open-type liquid manipulation device according to the aspect can efficiently divide liquid, in particular, a droplet. Thus, the open-type liquid manipulation device can provide an enhanced ability to control liquid, in particular, a droplet.

### [Brief Description of Drawings]

[Fig. 1] Fig. 1 is a plan view schematically showing an open-type liquid manipulation device according to a First Embodiment in a state before a droplet is divided.
[Fig. 2] Fig. 2 is a sectional view taken along line A-A of Fig. 1.
[Fig. 3] Fig. 3 is a plan view schematically showing the open-type liquid manipulation device according to the First Embodiment in a state after the droplet is divided.
[Fig. 4] Fig. 4 is a perspective view schematically showing an open-type liquid manipulation device according to a Second Embodiment in a state after a droplet is divided.
[Fig. 5] Fig. 5 is a sectional view taken along line B-B of Fig. 4, schematically showing a state before the droplet is divided.
[Fig. 6] Fig. 6 is a perspective view schematically showing an open-type liquid manipulation device according to a Third Embodiment in a state after a droplet is divided.
[Fig. 7] Fig. 7 is a sectional view taken along line C-C of Fig. 6, schematically showing a state before the droplet is divided.
[Fig. 8] Fig. 8 is a plan view schematically showing the open-type liquid manipulation device according to the Second Embodiment in a state before a droplet is divided.
[Fig. 9] Fig. 9 is a plan view schematically showing the open-type liquid manipulation device according to the Second Embodiment in a state after a droplet is divided into two divided portions having the same amounts.
[Fig. 10] Fig. 10 is a plan view schematically showing the open-type liquid manipulation device according to the Second Embodiment in a state after a droplet is divided into three divided portions having the same amounts.
[Fig. 11] Fig. 11 is a plan view schematically showing the open-type liquid manipulation device according to the Second Embodiment in a state after a droplet is divided into two divided portions having different amounts.

### [Description of Embodiments]

Open-type liquid manipulation devices according to First to Third Embodiments are described below. As described herein, a "film" indicates an object having a layer shape and having a thickness of approximately 200 µm (micrometer) or less, and a "sheet" indicates an object having a layer shape and having a thickness exceeding approximately 200 µm.

### "First Embodiment"

An open-type liquid manipulation device according to a First Embodiment is described below.

### "Basic Configuration of Liquid Manipulation Device"

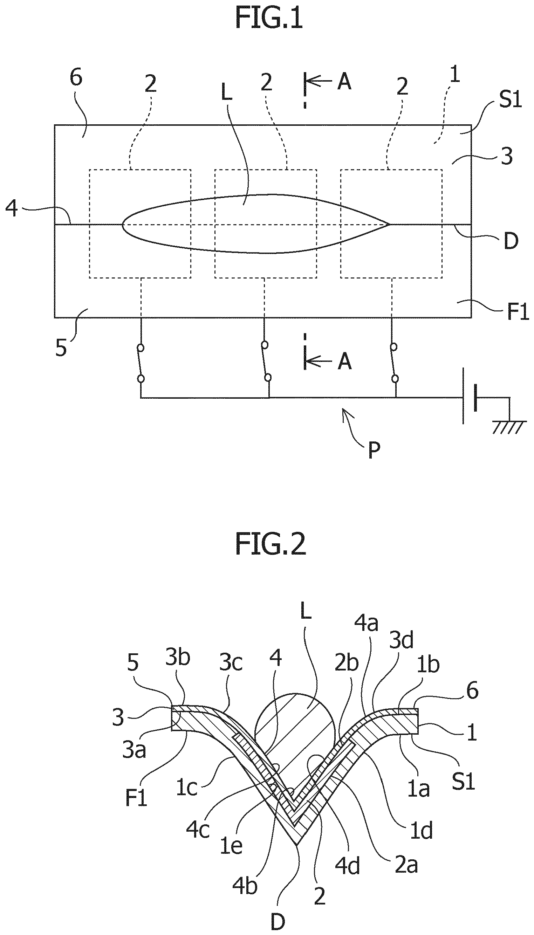

With reference to Figs. 1 to 3, a basic configuration of the liquid manipulation device according to the present Embodiment is described below. The liquid manipulation device (hereinafter referred to simply as "device" as necessary) according to the present Embodiment is basically as described below. The device includes a substrate 1, and the substrate 1 has a back surface 1a, and a front surface 1b located opposite the back surface 1a with respect to a thickness direction of the substrate 1.

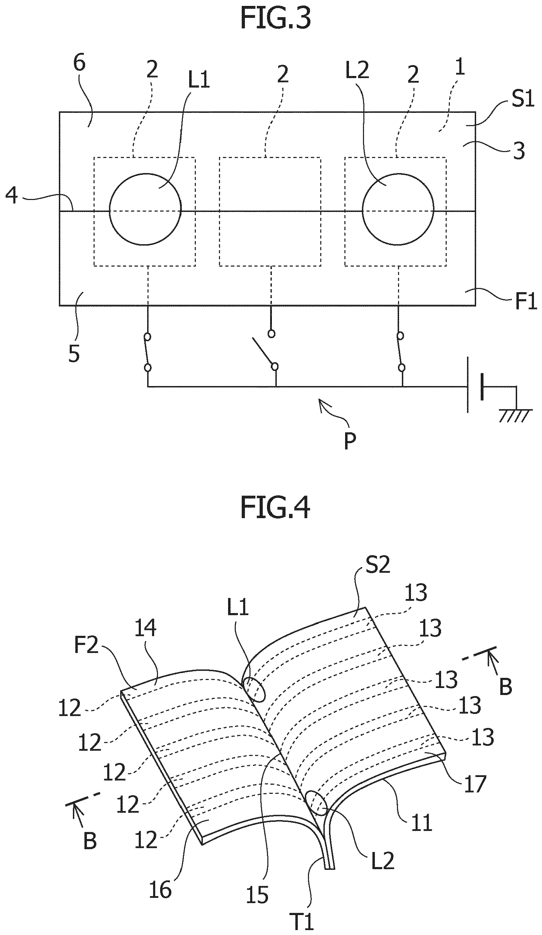

The device includes at least three electrodes 2 located on the front surface 1b of the substrate 1. In Figs. 1 and 3, three electrodes 2 are shown. However, the device can include four or more electrodes. The electrode 2 has: a back surface 2a facing the front surface 1b of the substrate 1; and a front surface 2b located opposite the back surface 2a of the electrode 2 with respect to a thickness direction of the electrode 2.

In Fig. 2, the substrate 1 includes a concave portion 1e that is concave to correspond to an associated one of the electrodes 2. Alternatively, the substrate can include no concave portions, and the electrodes may be placed on the front surface of the substrate using, for example, a printer, such as an ink jet printer or the like.

The device also includes an insulating layer 3 located over the front surface 1b of the substrate 1 to cover the at least three electrodes 2. The insulating layer 3 has: a back surface 3a facing the front surface 1b of the substrate 1; and a front surface 3b located opposite the back surface 3 a of the insulating layer 3 with respect to a thickness direction of the insulating layer 3. The front surface 3b of the insulating layer 3 is open to the outside. Thus, the device is an open type.

The device is configured to control liquid L on the front surface 3b of the insulating layer 3 by using a change in electrostatic force caused by changing voltage applied to the at least three electrodes 2. The device also includes a groove 4 that is concave in a direction from the front surface 3b of the insulating layer 3 toward the back surface 3a of the insulating layer 3. The groove 4 extends straddling the at least three electrodes 2. The groove 4 has an opening portion 4a, and a bottom portion 4b facing the opening portion 4a.

The groove 4 may decrease in width as it extends from the opening portion 4a toward the bottom portion 4b. However, this is not a limitation to the groove. For example, the width of the groove can be substantially uniform.

The substrate 1 includes: a first portion 1c located on one side of the bottom portion 4b of the groove 4 in a width direction of the groove 4; and a second portion 1d located on the other side of the bottom portion 4b in the width direction. The insulating layer 3 includes: a first portion 3c located on the one side of the bottom portion 4b of the groove 4 in the width direction of the groove 4; and a second portion 3d located on the other side of the bottom portion 4b in the width direction. The groove 4 includes: a first wall portion 4c located on the one side of the bottom portion 4b of the groove 4 in the width direction of the groove 4; and a second wall portion 4d located on the other side of the bottom portion 4b in the width direction. Each of the first and second wall portions 4c and 4d extends between the opening portion 4a and the bottom portion 4b of the groove 4. The device includes: a first lateral region 5 located on one side of the groove 4 in the width direction of the groove 4; and a second lateral region 6 located on the other side of the groove 4 in the width direction.

The device includes: a first structure F1 located on the one side of the bottom portion 4b of the groove 4 in the width direction of the groove 4; and a second structure S1 located on the other side of the bottom portion 4b in the width direction. The first structure F1 includes the first portion 1c of the substrate 1 and the first portion 3c of the insulating layer 3. The first wall portion 4c of the groove 4 and the first lateral region 5 are located on the first structure F1. The second structure S1 includes the second portion 1d of the substrate 1 and the second portion 3d of the insulating layer 3. The second wall portion 4d of the groove 4 and the second lateral region 6 are located on the second structure S1.

### "Specific Configuration of Liquid Manipulation Device"

With reference to Figs. 1 to 3, a specific configuration of the liquid manipulation device according to the present Embodiment is described below. The device according to the present Embodiment may be as described below specifically. The substrate 1 has a sheet shape or a film shape so as to have flexibility. The substrate 1, the at least three electrodes 2, and the insulating layer 3 are bent so as to form the groove 4 by including a bent portion D at which the substrate 1, the at least three electrodes 2, and the insulating layer 3 are bent to form the bottom portion 4b of the groove 4.

The first and second structures F1 and S1 are formed integrally. Thus, the first and second portions 1c and 1d of the substrate 1 are formed integrally, and the first and second portions 3c and 3d of the insulating layer 3 are formed integrally. Each of the electrodes 2 is located on both of the first and second structures F1 and S1. Each of the electrodes 2 is located on both of the first and second wall portions 4c and 4d of the groove 4.

### "Specific Configuration of Substrate"

With reference to Figs. 1 to 3, a specific configuration of the substrate 1 is described below. The substrate 1 may be as described below specifically. The substrate 1 may be made using paper, resin, and/or the like. As used herein, "paper" indicates a material fabricated by aggregating plant fibers, other fibers, and/or the like. The material may additionally include: an inorganic substance, such as a porous material and/or the like; and organic molecules, such as synthetic molecules and/or the like. As used herein, "resin" indicates a material including a natural and/or synthetic macromolecular compound as the principal component. The material may be a composite material further including fiber, an inorganic substance, and/or the like. In particular, "resin" may be thermoplastic resin, which can be processed with heat easily. The substrate 1 may be plastically deformable in a bending process. The substrate 1 may also be easily cuttable using a cutting tool, such as scissors, a cutter, and/or the like. The substrate 1 can be an injection molding made of resin.

The thickness of the substrate 1 is set such that the substrate 1 has flexibility. For example, when the substrate 1 is made using paper or is paper, the substrate 1 can have a thickness of approximately 100 µm to approximately 200 µm. When the substrate 1 is made using resin or is resin, the substrate 1 may be a film having a thickness of approximately 200 µm or less, or a sheet having a thickness exceeding approximately 200 µm. It is preferable that the substrate 1 not be made using glass or silicon. However, these are no limitations to the material and thickness of the substrate of the present invention.

### "Specific Configuration of Electrode"

With reference to Figs. 1 to 3, a specific configuration of the electrode 2 is described below. The electrode 2 may be as described below specifically. The electrode 2 is made of a conductive material. The conductive material may be a material such as metal, carbon, metallic oxide, a material containing at least one material among the materials set forth, or the like. The electrode 2 has a layer shape. The electrode can be formed using, for example, a conductive ink. The thickness of the electrode 2 is set to allow plastic deformation of the electrode 2 and the insulating layer 3 together during the bending process.

In Fig. 2, the electrode 2 is located within the concave portion 1e of the substrate 1 with the front surface 2b of the electrode 2 substantially coincident with the front surface 1b of the substrate 1. However, when the substrate includes no concave portions as described above, the front surface of the electrode protrudes from the front surface of the substrate.

The at least three electrodes 2, that is, three or more electrodes 2, are spaced apart from one another on the front surface 1b of the substrate 1 along the groove 4. In Figs. 1 and 3, when the groove 4 extends substantially straight as described below, the three or more electrodes 2 are spaced apart from one another along the groove 4. Furthermore, the three or more electrodes 2 can have their respective centers passing along the substantially straight groove 4. If, in this state, an imaginary straight line is drawn to connect the opposite ends of the substantially straight groove 4, the three or more electrodes 2, or their centers, are located on the imaginary straight line. However, this is not a limitation to the locations of the electrodes. When, for example, the groove is curved as it extends as described below, three or more electrodes can be spaced apart from one another along the curved groove. Furthermore, the centers of the three or more electrodes can pass along the curved groove. If, in this state, an imaginary straight line is drawn to connect the opposite ends of the curved groove, at least one electrode among the three or more electrodes is, or their centers are, shifted from the imaginary straight line in a direction substantially orthogonal to the imaginary straight line on the front surface of the substrate.

The at least three electrodes 2 are connected to a circuit P. The circuit P is configured to apply voltage to the electrodes 2 individually. In Figs. 1 and 3, the circuit P is located outside the substrate 1. However, this is not a limitation to the present invention. At least a portion of the circuit may be located in the substrate. A portion of the circuit, for example, a wiring and/or the like, may be located in the substrate.

Figs. 1 and 3 schematically show the circuit P including a switch, a power supply, grounding, and the like as an example to describe states in which voltage is applied to the at least three electrodes 2 individually. However, the circuit connected to the electrodes is not limited to the circuit P shown in Figs. 1 and 3. The circuit can have any configuration as long as voltage can be applied to the electrodes individually to generate electrostatic force for stopping and moving a droplet.

### "Specific Configuration of Insulating Layer"

With reference to Figs. 1 to 3, a specific configuration of the insulating layer 3 is described below. The insulating layer 3 may be as described below specifically. The insulating layer 3 may be electrically insulating. The insulating layer 3, in particular, the front surface 3b of the insulating layer 3, may be hydrophobic. The insulating layer 3 may thus be made using an electrically insulating and hydrophobic material. The material may be an electrically insulating and hydrophobic resin, for example, fluororesin or the like. The front surface of the insulating layer can be made using a hydrophobic material or an electrically insulating and hydrophobic material, and the remaining portion of the insulating layer can be made using an electrically insulating material.

### "Specific Configurations of Groove and Lateral Regions"

With reference to Figs. 1 to 3, specific configurations of the groove 4 and the lateral regions 5 and 6 are described below. The groove 4 and the lateral regions 5 and 6 may be as described below specifically. The groove 4 extends substantially straight. However, the groove may be curved as it extends. The groove 4 may have a depth greater than the width of the groove 4. However, the depth and width of the groove may be substantially the same. Alternatively, the groove can have a depth smaller than the width of the groove.

The groove 4 has a sectional area that is set to reduce the surface tension of liquid L in the groove 4. In particular, the sectional area of the groove 4 may be set to cause the solid-liquid interface of the liquid L in the groove 4 to be greater than the gas-liquid interface or liquid-liquid interface of the liquid L in the groove 4. When the liquid L is manipulated in gas, in particular, in air, the sectional area of the groove 4 may be set to cause the solid-liquid interface of the liquid L to be greater than the gas-liquid interface of the liquid L in the groove 4. When the liquid L is manipulated in another liquid that generates a liquid-liquid interface with the liquid L, the sectional area of the groove 4 may be set to cause the solid-liquid interface of the liquid L in the groove 4 to be greater than the liquid-liquid interface. For example, the other liquid may be oil. However, this is not a limitation to the different liquid. Furthermore, the groove 4 may decrease in width as it extends from the opening portion 4a toward the bottom portion 4b such that capillary action of the liquid L in the groove 4 occurs due to wetting.

The bottom portion 4b of the groove 4 has a substantially wedge shape. The bottom portion 4b may have a wedge shape having a predefined angle. The angle may be acute. Furthermore, the angle may be set such that capillary action of the liquid L in the groove 4 can occur due to wetting. However, the bottom portion may be curved. The bottom portion may be substantially flat. The distance between the first and second wall portions 4c and 4d of the groove 4 becomes narrower toward the bottom portion 4b from the opening portion 4a of the groove 4. The first and second wall portions 4c and 4d are curved. In particular, the first and second wall portions 4c and 4d are curved to protrude toward each other. However, the first and second wall portions may be curved concave in a direction away from each other. The first and second wall portions may be substantially straight.

The first and second lateral regions 5 and 6 are located along the width direction of the groove 4. However, the second lateral region may extend substantially straight together with the second wall portion of the groove, which is continuous with the second lateral region, and the first lateral region may be bent from the first wall portion of the groove, which is continuous with the first lateral region, and extend therefrom.

### "Fabrication Method for Liquid Manipulation Device"

An example fabrication method for the liquid manipulation device according to the present Embodiment is described below. First, a material for the device, which is not specifically shown, is prepared. In the material, the first and second structures F1 and S1 are integrally formed to be smoothly continuous. The material for the device is bent so as to form the groove 4 by including the bent portion D, at which the material for the device is bent to form the bottom portion 4b of the groove 4. As a result, the device according to the present Embodiment is fabricated.

### "Dividing Method for Liquid"

With reference to Figs. 1 and 3, an example method for dividing liquid L (a dividing method for liquid L) on the liquid manipulation device according to the present Embodiment is described below. A method for dividing liquid L, in particular, a droplet L into two portions L1 and L2 having the same amount is described here. As shown in Fig. 1, the device is first brought into a state in which a voltage is applied to the at least three electrodes 2. At this point in time, the liquid L is retained as one body, extending along the groove 4 on the at least three electrodes 2.

As shown in Fig. 3, the device is then brought into a state in which voltage remains applied to the electrodes 2 located on both sides of the longitudinal ends of the groove 4 among the at least three electrodes 2, and no voltage is applied to a middle electrode 2 located between the electrodes 2 at both ends among the at least three electrodes 2. Here, one portion L1 of the liquid L located on one side of the groove 4 in the longitudinal direction, moves toward the electrode 2 located at the end on the one side due to electrostatic force generated by this electrode 2. Also, the other portion L2 of the liquid L located on the other side of the groove 4 in the longitudinal direction, moves toward the electrode 2 located at the end on the other side due to electrostatic force generated by this electrode 2.

Furthermore, the surface tension of the liquid L is reduced due to the groove 4 as described above; thus, the one portion L1 and the other portion L2 of the liquid L are separated from each other between the electrodes 2 on both ends. After the separation, the one portion L1 of the liquid L is retained at a location corresponding to the electrode 2 at the end on the one side due to the electrostatic force generated by the electrode 2 at the end on the one side, and the other portion L2 of the liquid L is retained at a location corresponding to the electrode 2 at the end on the other side due to the electrostatic force generated by the electrode 2 at the end on the other side. However, the number and amounts of portions (hereinafter referred to as "divided portion" as needed) obtained through the division of the liquid L can be regulated on the liquid manipulation device. Specifically, the liquid L can be divided into three or more portions. Furthermore, the amounts of the divided portions can be changed. For example, one divided portion out of two or more divided portions can have an amount different from the other one or more divided portions. A method for regulating the number and amounts of divided portions of the liquid L will be described in detail hereinafter.

As described above, in the basic configuration, the open-type liquid manipulation device according to the present Embodiment includes: the substrate 1; the at least three electrodes 2 located on the front surface 1b of the substrate 1; and the insulating layer 3 located over the front surface 1b of the substrate 1 to cover the at least three electrodes 2. The device also includes the groove 4 that is concave in the direction from the front surface 3b of the insulating layer 3 toward the back surface 3a of the insulating layer 3. The groove 4 extends straddling the at least three electrodes 2. The groove 4 is set to cause the solid-liquid interface to be greater than the gas-liquid interface or liquid-liquid interface; thus, the effect of the surface tension on liquid L, in particular, a droplet L, placed in the groove 4, can be reduced. As a result, the liquid L, in particular, the droplet L can be efficiently divided as described in the aforementioned dividing method for liquid L. Thus, an enhanced ability to control liquid L, in particular, a droplet L can be provided.

In the basic configuration of the open-type liquid manipulation device according to the present Embodiment, the groove 4 decreases in width as the groove 4 extends from the opening portion 4a of the groove 4 toward the bottom portion 4b of the groove 4. The groove 4 having such a configuration can easily induce capillary action, thus causing liquid L, in particular, a droplet L to deform to thereby seep into the groove 4 easily. Thus, the effect of the surface tension of the liquid L in the groove 4 can be reduced. Therefore, liquid L, in particular, a droplet L, can be efficiently divided.

Furthermore, in the specific configuration of the open-type liquid manipulation device according to the present Embodiment, the substrate 1 has a sheet shape or a film shape so as to have flexibility, and the substrate 1, the at least three electrodes 2, and the insulating layer 3 are bent so as to form the groove 4 by including the bent portion D, at which the substrate 1, the at least three electrodes 2, and the insulating layer 3 are bent to form the bottom portion 4b of the groove 4. Thus, the groove 4, which can reduce the effect of the surface tension of the liquid L, can be easily formed. Therefore, when efficiency including fabrication efficiency in particular is taken into consideration, liquid L, in particular, a droplet L can be divided efficiently.

### "Second Embodiment"

An open-type liquid manipulation device according to a Second Embodiment is described below.

### "Basic Configuration of Liquid Manipulation Device"

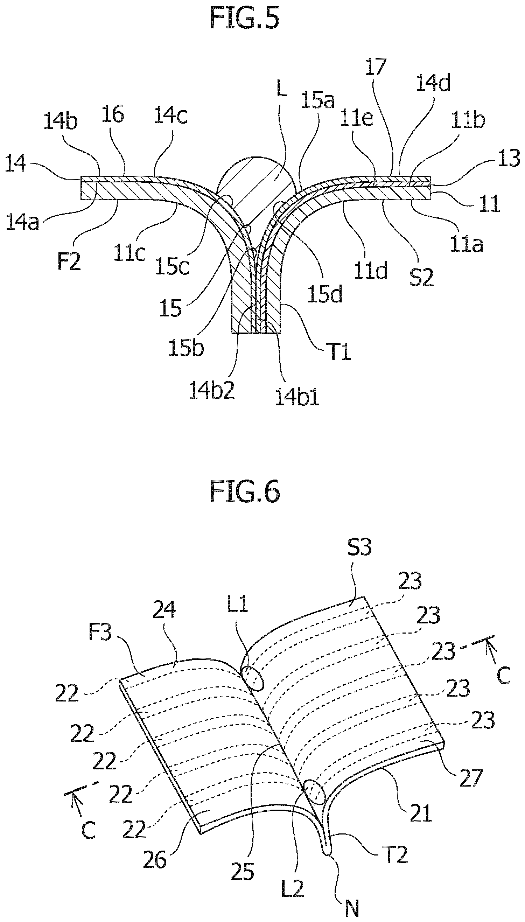

With reference to Figs. 4 and 5, a basic configuration of the liquid manipulation device according to the present Embodiment is described below. The device according to the present Embodiment is basically as described below. The basic configuration of the device according to the present Embodiment is similar to the basic configuration of the device according to the First Embodiment. The device according to the present Embodiment includes a substrate 11, at least three electrodes 12 and 13, an insulating layer 14, a groove 15, a first lateral region 16, a second lateral region 17, a first structure F2, and a second structure S2, which are configured similarly to the corresponding elements in the basic configuration of the device according to the First Embodiment.

The substrate 11 according to the present Embodiment includes a back surface 11a, a front surface 11b, a first portion 11c, a second portion 11d, and a concave portion 11e, which are configured similarly to the corresponding elements in the basic configuration of the device according to the First Embodiment. The insulating layer 14 according to the present Embodiment includes a back surface 14a, a front surface 14b, a first portion 14c, and a second portion 14d, which are configured similarly to the corresponding elements in the basic configuration of the device according to the First Embodiment. The groove 15 according to the present Embodiment includes an opening portion 15a, a bottom portion 15b, a first wall portion 15c, and a second wall portion 15d, which are configured similarly to the corresponding elements in the basic configuration of the device according to the First Embodiment.

### "Specific Configuration of Liquid Manipulation Device"

With reference to Figs. 4 and 5, a specific configuration of the liquid manipulation device according to the present Embodiment is described below. The device according to the present Embodiment may be as described below specifically. The first portion 11c of the substrate 11 has a sheet shape or a film shape so as to have flexibility.

The at least three electrodes 12 and 13 are allocated between the first and second structures F2 and S2. The at least three electrodes 12 and 13 include: a first electrode 12 located on one side of the bottom portion 15b of the groove 15 in a width direction of the groove 15; and a second electrode 13 located on the other side of the bottom portion 15b in the width direction. The first and second electrodes 12 and 13 are spaced apart from one another. In detail, the at least three electrodes 12 and 13 are made up of at least two first electrodes 12 and at least one second electrode 13, or alternatively, at least one first electrode 12 and at least two second electrodes 13. However, all of the at least three electrodes may be located in one of the first and second structures. Fig. 4 shows the first structure F2 including five first electrodes 12, and the second structure S2 including five second electrodes 13. However, these are not limitations to the numbers of the first and second electrodes.

The first structure F2 includes the first electrodes 12 in addition to the first portion 11c of the substrate 11 and the first portion 14c of the insulating layer 14. The second structure S2 includes the second electrodes 13 in addition to the second portion 11d of the substrate 11 and the second portion 14d of the insulating layer 14. The first structure F2 is bent so as to form the groove 15 in cooperation with the second structure S2 by including a contact portion T1 at which front surfaces 14b1 and 14b2 of the first and second portions 14c and 14d of the insulating layer 14 are in contact with each other to form the bottom portion 15b of the groove 15.

The second portion 11d of the substrate 11 has a sheet shape or a film shape so as to have flexibility, and the second structure S2 is bent so as to form the groove 15 in cooperation with the first structure F2. However, this is not a limitation to the present invention. The second structure can be substantially flat so as to form the groove in cooperation with the first structure. In this case, the second portion of the substrate can have a sheet shape or a film shape so as to have flexibility, or alternatively, can be formed to have rigidity.

Furthermore, a portion or the entirety of the first electrode 12 is located at the first wall portion 15c of the groove 15. A portion or the entirety of the second electrode 13 is located at the second wall portion 15d of the groove 15. Fig. 4 shows an example in which a portion of each of the first electrodes 12 is located at the first wall portion 15c of the groove 15, and a portion of each of the second electrodes 13 is located at the second wall portion 15d of the groove 15. The first and second electrodes 12 and 13 are arranged along the longitudinal direction of the groove 15. In Fig. 4, the first and second electrodes 12 and 13 are arranged along the longitudinal direction of the groove 15. However, this is not a limitation to how the first and second electrodes are arranged.

The first and second structures F2 and S2 are separate bodies. Thus, the first portion 11c of the substrate 11 and the first portion 14c of the insulating layer 14 are separate bodies, and the second portion 11d of the substrate 11 and the second portion 14d of the insulating layer 14 are separate bodies. The first and second electrodes 12 and 13 are of course also separate bodies.

### "Specific Configurations of Substrate, Electrodes, Insulating Layer, Groove, and Lateral Regions"

With reference to Figs. 4 and 5, specific configurations of the substrate 11, the electrodes 12 and 13, the insulating layer 14, the groove 15, and the lateral regions 16 and 17 are described below. The substrate 11, the electrodes 12 and 13, the insulating layer 14, the groove 15, and the lateral regions 16 and 17 may be as described below specifically. As described above, the second portion 11d of the substrate 11 has a sheet shape or a film shape so as to have flexibility. However, the second portion of the substrate can be formed to have rigidity as described above. In this case, the second portion of the substrate can be made using glass, silicon, and/or the like. Also, the thickness of the second portion of the substrate can be set to impart rigidity to the substrate.

The first and second portions 11c and 11d of the substrate 11 are configured similarly to the corresponding elements in the specific configuration of the substrate 1 according to the First Embodiment. The second portion 11d of the substrate 11 can be configured similarly to the first portion 11c of the substrate 11, except for the positional relationship with the first portion 11c. However, the first and second portions of the substrate can be configured differently from each other.

The at least three electrodes 12 and 13, in particular, the first and second electrodes 12 and 13 are configured similarly to the electrodes 2 in the specific configuration of the First Embodiment. The second electrode 13 can be configured similarly to the first electrode 12, except for the positional relationship with the first electrode 12. However, the first and second electrodes can be configured differently from each other.

The first and second portions 14c and 14d of the insulating layer 14 are configured similarly to the corresponding elements in the specific configuration of the insulating layer 14 according to the First Embodiment. The second portion 14d of the insulating layer 14 can be configured similarly to the first portion 14c of the insulating layer 14, except for the positional relationship with the first portion 14c. However, the first and second portions of the insulating layer can be configured differently from each other.

The groove 15 is configured similarly to the groove 4 in the specific configuration of the First Embodiment. The first and second lateral regions 16 and 17 are configured similarly to the first and second lateral regions 5 and 6, respectively, according to the First Embodiment. When the second portion of the substrate is formed to have rigidity as described above, the second lateral region extends substantially straight together with the second wall portion of the groove, which is continuous with the second lateral region, and the first lateral region is bent from the first wall portion of the groove, which is continuous with the first lateral region, and extends therefrom.

### "Fabrication Method for Liquid Manipulation Device"

An example fabrication method for the liquid manipulation device according to the present Embodiment is described below. First, the first structure F2 and the second structure S2 as separate bodies, which are not specifically depicted, are prepared. The first structure F2 is bent so as to form the groove 15 in cooperation with the second structure S2 by including the contact portion T1, at which the front surfaces 14b 1 and 14b2 of the first and second portions 14c and 14d of the insulating layer 14 are in contact with each other to form the bottom portion 15b of the groove 15. The front surfaces 14b 1 and 14b2 of the first and second portions 14c and 14d of the insulating layer 14 are attached together at the contact portion T1 by clipping, gluing, and/or the like. As a result, the device according to the present Embodiment is fabricated.

The dividing method for liquid L according to the present Embodiment is similar to the dividing method for liquid according to the First Embodiment.

In the basic configuration of the open-type liquid manipulation device according to the present Embodiment, operation and effects, similar to those in the basic configuration of the liquid manipulation device according to the First Embodiment, can be obtained. Furthermore, in the specific configuration of the open-type device according to the present Embodiment, the first portion 11c of the substrate 11 has a sheet shape or a film shape so as to have flexibility; the at least three electrodes 12 and 13 are allocated between the first structure F2, which includes the first portion 11c of the substrate 11 and the first portion 14c of the insulating layer 14, and the second structure S2, which includes the second portion 11d of the substrate 11 and the second portion 14d of the insulating layer 14, or alternatively, the at least three electrodes 12 and 13 are located in one of the first and second structures F2 and S2; and the first structure F2 is bent so as to form the groove 15 in cooperation with the second structure S2 by including the contact portion T1, at which the front surfaces 14b1 and 14b2 of the first and second portions 14c and 14d of the insulating layer 14 are in contact with each other to form the bottom portion 15b of the groove 15. Thus, the groove 15, which can reduce the effect of the surface tension of liquid L, in particular, a droplet L, can be formed easily. Therefore, when efficiency including fabrication efficiency in particular is taken into consideration, liquid L, in particular, a droplet L can be divided efficiently.

In the specific configuration of the open-type liquid manipulation device according to the present Embodiment, the first and second structures F2 and S2 are separate bodies.

Thus, by assembling the separate first and second structures F2 and S2 to form the groove 15 by including the contact portion T1 by, for example, clipping, gluing, and/or the like, the groove 15, which can reduce the effect of the surface tension of liquid L, in particular, a droplet L, can be formed easily. Therefore, when efficiency including fabrication efficiency in particular is taken into consideration, liquid L, in particular, a droplet L can be divided efficiently.

In the specific configuration of the open-type liquid manipulation device according to the present Embodiment, the second portion 11d of the substrate 11 has a sheet shape or a film shape so as to have flexibility, and the second structure S2 is bent so as to form the groove 15 in cooperation with the first structure F2; thus, the groove 15, which can reduce the effect of the surface tension of liquid L, in particular, a droplet L, can be formed easily. Therefore, when efficiency including fabrication efficiency in particular is taken into consideration, liquid 15, in particular, a droplet 15 can be divided efficiently.

In the specific configuration of the open-type liquid manipulation device according to the present Embodiment, the groove, which can reduce the effect of the surface tension of liquid, in particular, a droplet, can also be formed easily when the second structure is substantially flat so as to form the groove in cooperation with the first structure. Therefore, when efficiency including fabrication efficiency in particular is taken into consideration, liquid, in particular, a droplet, can be divided efficiently.

### "Third Embodiment"

An open-type liquid manipulation device according to a Third Embodiment is described below.

### "Basic Configuration of Liquid Manipulation Device"

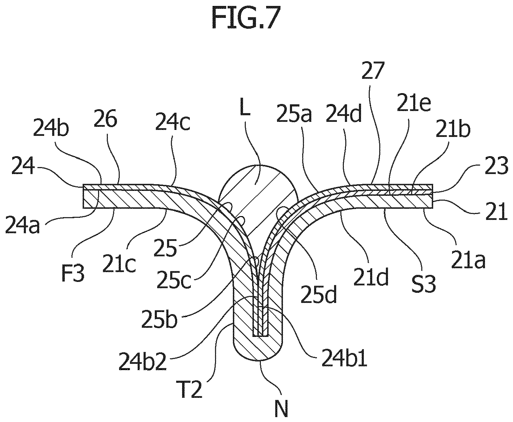

With reference to Figs. 6 and 7, a basic configuration of the liquid manipulation device according to the present Embodiment is described below. The device according to the present Embodiment is as described below basically. The basic configuration of the device according to the present Embodiment is similar to the basic configuration of the device according to the First Embodiment or the Second Embodiment. The device according to the present Embodiment includes a substrate 21, at least three electrodes 22 and 23, an insulating layer 24, a groove 25, a first lateral region 26, a second lateral region 27, a first structure F3, and a second structure S3, which are configured similarly to the corresponding elements in the basic configuration of the device according to the First Embodiment or the Second Embodiment. Fig. 6 shows the first structure F3 including five first electrodes 22, and the second structure S3 including five second electrodes 23. However, these are not limitations to the numbers of the first and second electrodes.

The substrate 21 according to the present Embodiment includes a back surface 21a, a front surface 21b, a first portion 21c, a second portion 21d, and a concave portion 21e, which are configured similarly to the corresponding elements in the basic configuration of the device according to the First Embodiment or the Second Embodiment. The insulating layer 24 according to the present Embodiment includes a back surface 24a, a front surface 24b, a first portion 24c, and a second portion 24d, which are configured similarly to the corresponding elements in the basic configuration of the device according to the First Embodiment or the Second Embodiment. The groove 25 according to the present Embodiment includes an opening portion 25a, a bottom portion 25b, a first wall portion 25c, and a second wall portion 25d, which are configured similarly to the corresponding elements in the basic configuration of the device according to the First Embodiment or the Second Embodiment.

### "Specific Configuration of Liquid Manipulation Device"

With reference to Figs. 6 and 7, a specific configuration of the liquid manipulation device according to the present Embodiment is described below. The device according to the present Embodiment may be as described below specifically. The specific configuration of the device according to the present Embodiment is similar to the specific configuration of the device according to the Second Embodiment, except that the first and second structures F3 and S3 are formed integrally.

Since the first and second structures F3 and S3 of the device are integrally formed, the first portion 21c of the substrate 21 and the first portion 24c of the insulating layer 24 are integrally formed, and the second portion 21d of the substrate 21 and the second portion 24d of the insulating layer 24 are integrally formed. The first and second electrodes 12 and 13 are separate bodies. The first electrode can have: a main body portion located on the first structure; and an extension portion extending from the main body portion beyond the first structure to reach the second structure. Also, the second electrode can have: a main body portion located on the second structure; and an extension portion extending from the main body portion beyond the second structure to reach the first structure.

The first and second structures F3 and S3 are integrally formed and connected at a connection portion N located, on the back surface 21a side of a substrate 21, in a contact portion T2 corresponding to the contact portion T1 of the Second Embodiment. The connection portion N has an arc shape. However, the connection portion can have substantially a drop shape having a hollow space and extending along the longitudinal direction of the groove.

### "Specific Configurations of Substrate, Electrodes, Insulating Layer, Groove, and Lateral Regions"

With reference to Figs. 6 and 7, specific configurations of the substrate 21, the electrodes 22 and 23, the insulating layer 24, the groove 25, and the lateral regions 26 and 27 are described below. The substrate 21, the electrodes 22 and 23, the insulating layer 24, the groove 25, and the lateral regions 26 and 27 may be as described below specifically. Since the first portion 21c of the substrate 21 and the first portion 24c of the insulating layer 24 are integrally formed, the second portion 21d of the substrate 21 also has a sheet shape or a film shape so as to have flexibility. The substrate 21 is configured similarly to the substrate 1 in the specific configuration of the First Embodiment.

The at least three electrodes 12 and 13, in particular, the first and second electrodes 22 and 23 are configured similarly to the electrodes 2 in the specific configuration of the First Embodiment. The second electrode 23 can be configured similarly to the first electrode 22, except for the positional relationship with the first electrode 22. However, the first and second electrodes can be configured differently from each other.

The insulating layer 24 is configured similarly to the insulating layer 3 according to the First Embodiment in the specific configuration. The groove 25 is configured similarly to the groove 4 according to the First Embodiment in the specific configuration. The first and second lateral regions 26 and 27 are configured similarly to the first and second lateral regions 5 and 6, respectively, according to the First Embodiment.

### "Fabrication Method for Liquid Manipulation Device"

An example fabrication method for the liquid manipulation device according to the present Embodiment is described below. First, a material for the device, which is not specifically shown, is prepared. In the material, the first and second structures F1 and S1 are integrally formed to be smoothly continuous. The material for the device is bent so as to form the groove 25 by including: the contact portion T2, at which front surfaces 24b 1 and 24b2 of the first and second portions 24c and 24d of the insulating layer 24 are in contact with each other to form the bottom portion 25b of the groove 25; and the connection portion N located, on the back surface 21a side of the substrate 21, in the contact portion T2. The front surfaces 24b 1 and 24b2 of the first and second portions 24c and 24d of the insulating layer 24 are attached together at the contact portion T2 by clipping, gluing, and/or the like. As a result, the device according to the present Embodiment is fabricated.

The dividing method for liquid L according to the present Embodiment is similar to the dividing method for liquid according to the First Embodiment or the Second Embodiment.

In the basic configuration of the open-type liquid manipulation device according to the present Embodiment, operation and effects, similar to those in the basic configuration of the liquid manipulation device according to the First Embodiment, can be obtained. Furthermore, in the specific configuration of the open-type liquid manipulation device according to the present Embodiment, operation and effects, similar to those in the specific configuration of the liquid manipulation device according to the Second Embodiment, can be obtained, except for operation and effects based on the first and second structures F2 and S2, which are separate bodies.

In the specific configuration of the open-type liquid manipulation device according to the present Embodiment, the first and second structures F3 and S3 are formed integrally. Thus, by assembling the integrally formed first and second structures F3 and S3 to form the groove 25 by including the contact portion T2 and the connection portion N as described above by, for example, clipping, gluing, and/or the like, the groove 25, which can reduce the effect of the surface tension of liquid L, in particular, a droplet L, can be formed easily. Therefore, when efficiency including fabrication efficiency in particular is taken into consideration, liquid L, in particular, a droplet L can be divided efficiently.

### "Method for Regulating the Number and Amounts of Divided Portions of Liquid in Detail"

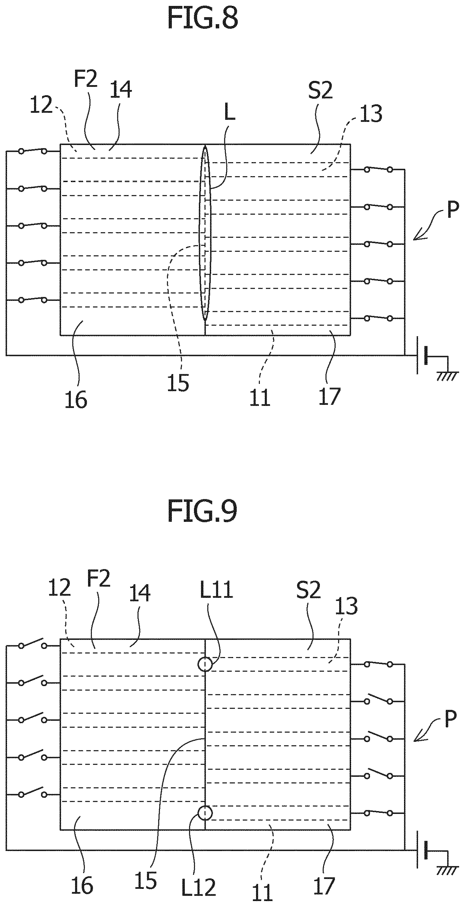

With reference to Figs. 8 to 11, a method for regulating the number and amounts of divided portions of liquid L is described in detail below. For the description, the liquid manipulation device according to the Second Embodiment is used. However, the method for regulating the number and amounts of divided portions of liquid L can be performed on the liquid manipulation devices of the present invention including the First to Third Embodiments.

On the liquid manipulation device, liquid L can be divided to provide m divided portions, in which m is an integer of 2 or more. Here, the total number of the electrodes 12 and 13 in the liquid manipulation device is (2m - 1) or more. In the liquid manipulation device according to the Second Embodiment, the total number of the first and second electrodes 12 and 13 is (2m - 1) or more. In Figs. 8 to 11, the (2m - 1) or more electrodes 12 and 13 are connected to a circuit P as in the First Embodiment. The circuit P is configured to apply voltage to the (2m - 1) or more electrodes 12 and 13 individually.

As shown in Fig. 8, the device is first brought into a state in which voltage is applied to the (2m - 1) or more electrodes 12 and 13. At this point in time, the liquid L is retained as one body, extending along the groove 15, on the (2m - 1) or more electrodes 12 and 13.

As shown in Figs. 9 to 11, the device is then brought into a state in which voltage remains applied to m electrode elements, each electrode element made up of: one electrode 12 or 13; or two or more adjacent electrodes 12 and 13 (an electrode element made up of an electrode or electrodes to which voltage remains applied is hereinafter referred to as "applied-electrode element"). In this state, voltage application to the remaining electrodes 12 and 13 is stopped (electrodes to which voltage application is stopped are hereinafter referred to as "non-applied electrodes"). Between neighboring applied-electrode elements, at least one non-applied electrode 12 or 13 is located. Thus, m divided portions move toward the respective m applied-electrode elements due to electrostatic force generated by the m applied-electrode elements.

Furthermore, the surface tension of the liquid L is reduced due to the groove 15; thus, the liquid L is separated from each other between the neighboring applied-electrode elements to be divided into the m divided portions. After the separation, the m divided portions are retained at respective locations corresponding to the m applied-electrode elements due to electrostatic force generated by the respective m applied-electrode elements.

The number of divided portions can be regulated by changing the number of applied-electrode elements in the device. The amount of each divided portion can be regulated by changing the number of electrodes 12 and 13 making up an applied-electrode element used to retain the divided portion. In particular, when lengths of the electrodes 12 and 13 in the longitudinal direction of the groove 15 are substantially the same, the amount of a divided portion can be increased or decreased in proportion to the number of the electrodes 12 and 13 making up the applied-electrode element.

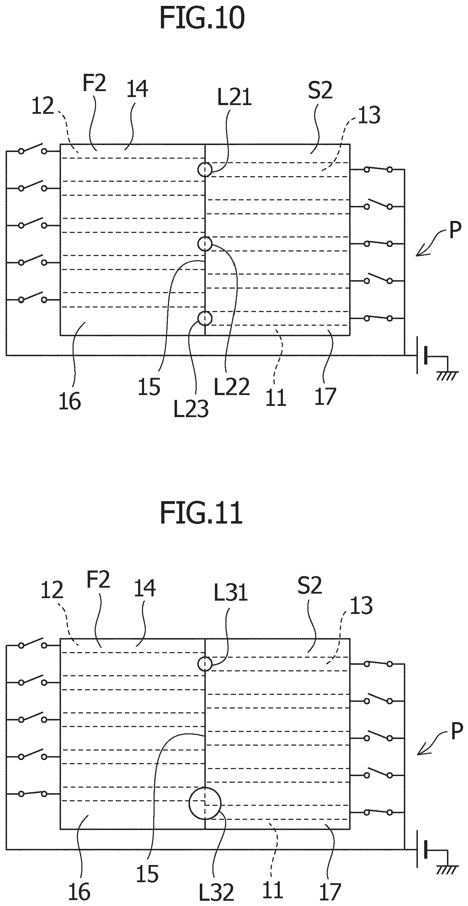

In an example, as shown in Fig. 9, two divided portions L11 and L12 having the same amounts can be obtained by using two applied-electrode elements each made up of one electrode 12 or 13. In another example, as shown in Fig. 10, three divided portions L21, L22, and L23 having the same amounts can be obtained by using three applied-electrode elements each made up of one electrode 12 or 13.

In yet another example, as shown in Fig. 11, two divided portions L31 and L32 having different amounts can be obtained by using one applied-electrode element made up of one electrode 12 or 13 and another one applied-electrode element made up of two adjacent electrodes 12 and 13. In this case, the lengths of the electrodes 12 and 13 in the longitudinal direction of the groove 15 are substantially the same, and the amount of the divided portion L32, retained at a location corresponding to the other one applied electrode element, is approximately twice the amount of the divided portion L31, retained at a location corresponding to the one applied-electrode element. However, regulation of the number and the amounts of divided portions are not limited to the modes shown in Figs. 9 to 11.

While some embodiments of the present invention have been described above, the present invention is not limited to the aforementioned embodiments and can be modified or changed based on the technical concept of the present invention.

### [Industrial Applicability]

In use, the liquid manipulation device according to the present invention can be integrated in a device, such as a portable and disposable automated batch-type device, an assay device, and/or the like. Nonlimiting examples of such devices include: a reagent component sensor; a reagent formulation processing device; an automated reagent component selector; a closed microenvironment type isolated aseptic cell incubator; a synthesizer of artificial organs arranged per cell strain; and/or the like.

### [Reference Signs List]

1 ... substrate, 1b ... front surface, 2 ... electrode, 3 ... insulating layer, 3a ... back surface, 3b ... front surface, 4 ... groove, 4a ... opening portion, 4b ... bottom portion, D ... bent portion

11 ... substrate, 11b ... front surface, 11c ... first portion, 11d ... second portion, 12 ... first electrode (electrode), 13 ... second electrode (electrode), 14 ... insulating layer, 14a ... back surface, 14b, 14b1, 14b2 ... front surface, 14c ... first portion, 14d ... second portion, 15 ... groove, 15a ... opening portion, 15b ... bottom portion, F2 ... first structure, S2 ... second structure, T1 ... contact portion

21 ... substrate, 21b ... front surface, 21c ... first portion, 21d ... second portion, 22 ... first electrode (electrode), 23 ... second electrode (electrode), 24 ... insulating layer, 24a ... back surface, 24b, 24b1, 24b2 ... front surface, 24c ... first portion, 24d ... second portion, 25 ... groove, 25a ... opening portion, 25b ... bottom portion, F3 ... first structure, S3 ... second structure, T2 ... contact portion, N ... connection portion

L ... liquid (droplet)

## Claims

1. An open-type liquid manipulation device comprising:
a substrate;
at least three electrodes located on a front surface of the substrate; and
an insulating layer located over the front surface of the substrate to cover the at least three electrodes, wherein
the insulating layer has: a back surface facing the front surface of the substrate; and a front surface located opposite the back surface of the insulating layer with respect to a thickness direction of the insulating layer,
the front surface of the insulating layer is open to an outside,
the open-type liquid manipulation device is configured to control liquid on the front surface of the insulating layer by using a change in electrostatic force caused by changing voltage applied to the at least three electrodes,
the open-type liquid manipulation device comprises a groove that is concave in a direction from the front surface of the insulating layer toward the back surface of the insulating layer, and
the groove extends straddling the at least three electrodes.

2. The open-type liquid manipulation device as claimed in claim 1, wherein
the groove decreases in width as the groove extends from an opening portion of the groove toward a bottom portion of the groove.

3. The open-type liquid manipulation device as claimed in claim 2, wherein
the substrate includes a sheet shape or a film shape so as to have flexibility, and
the substrate, the at least three electrodes, and the insulating layer are bent so as to form the groove by including a bent portion at which the substrate, the at least three electrodes, and the insulating layer are bent to form the bottom portion of the groove.

4. The open-type liquid manipulation device as claimed in claim 1, wherein
the substrate includes: a first portion located on one side of a bottom portion of the groove in a width direction of the groove; and a second portion located on the other side of the bottom portion in the width direction,
the first portion of the substrate includes a sheet shape or a film shape so as to have flexibility,
the insulating layer includes: a first portion located on the one side of the bottom portion of the groove in the width direction of the groove; and a second portion located on the other side of the bottom portion in the width direction,
a first structure including the first portion of the substrate and the first portion of the insulating layer is located on the one side of the bottom portion of the groove in the width direction of the groove, and a second structure including the second portion of the substrate and the second portion of the insulating layer is located on the other side of the bottom portion in the width direction,
the at least three electrodes are either allocated between the first structure and the second structure, or located in one of the first structure and the second structure, and
the first structure is bent so as to form the groove in cooperation with the second structure by including a contact portion at which a front surface of the first portion of the insulating layer is in contact with a front surface of the second portion of the insulating layer to form the bottom portion of the groove.

5. The open-type liquid manipulation device as claimed in claim 4, wherein
the first structure and the second structure are separate bodies.

6. The open-type liquid manipulation device as claimed in claim 5, wherein
the second portion of the substrate includes a sheet shape or a film shape so as to have flexibility, and
the second structure is bent so as to form the groove in cooperation with the first structure.

7. The open-type liquid manipulation device as claimed in claim 5, wherein
the second structure is substantially flat so as to form the groove in cooperation with the first structure.

8. The open-type liquid manipulation device as claimed in claim 4, wherein
the first structure and the second structure are formed integrally.
